(19) **Europäisches Patentamt**

**European Patent Office**

**Office européen des brevets**

(11) **EP 0 746 114 B1**

(12) **FASCICULE DE BREVET EUROPEEN**

(45) Date de publication et mention
de la délivrance du brevet:
**18.07.2001 Bulletin 2001/29**

(51) Int Cl.⁷: **H04B 1/40**, H03C 3/00,
H03L 7/23

(21) Numéro de dépôt: **96401149.8**

(22) Date de dépôt: **29.05.1996**

(54) **Dispositif d'émission radio à modulation de fréquence**

Frequenzmodulierter Funksender

Frequency modulated radio transmitter

(84) Etats contractants désignés:
**ES FR GB IE NL PT**

(30) Priorité: **31.05.1995 FR 9506474**

(43) Date de publication de la demande:
**04.12.1996 Bulletin 1996/49**

(73) Titulaire: **MATRA NORTEL COMMUNICATIONS**
**29000 Quimper (FR)**

(72) Inventeurs:
• **Le Corre, Jean-Luc**
**29100 Quimper (FR)**

• **Robbe, Michel**
**78700 Conflans Sainte Honorine (FR)**

(74) Mandataire: **Loisel, Bertrand et al**
**Cabinet Plasseraud,**
**84, rue d'Amsterdam**
**75440 Paris Cédex 09 (FR)**

(56) Documents cités:
**DE-A- 3 005 952** **US-A- 4 932 072**
**US-A- 5 111 162**

## Description

La présente invention concerne un dispositif d'émission ou d'émission-réception radio à modulation de fréquence. Elle trouve une application particulière, mais non exclusive, dans les liaisons base/combiné pour des postes téléphoniques sans cordon.

Habituellement, les émetteurs/récepteurs en radiofréquence comportent deux boucles à phase asservie (PLL) indépendantes : l'une pour l'émission, l'autre pour la réception. Chacune de ces boucles comporte un oscillateur commandé en tension (OCT), un comparateur de phase, un diviseur et un filtre de boucle. Les filtres de boucle sont réalisés à partir de composants discrets, car les fréquences de coupure des boucles sont relativement basses, de l'ordre de 100 Hz dans le cas de la bande passante téléphonique (de 300 à 3400 Hz). Les OCT sont réalisés au moyen d'une inductance réglable et d'une capacité commandée en tension (varicap).

Il est connu de réaliser des oscillateurs commandés en tension à transistors (multivibrateurs astables) intégrables sur silicium. Mais ces OCT intégrés ont l'inconvénient de présenter un bruit de phase important, surtout s'ils doivent opérer à fréquence relativement élevée (par exemple quelques dizaines de MHz). La boucle peut compenser ce bruit de phase si son filtre passe-bas présente une fréquence de coupure suffisamment élevée (quelques dizaines de kHz typiquement), mais un tel filtre de boucle aurait pour effet d'éliminer la modulation souhaitée en même temps que le bruit de phase indésirable.

La demande de brevet allemand 30 05 952 décrit un synthétiseur de fréquences comprenant : (I) une PLL de modulation dont le filtre de boucle a une constante de temps relativement élevée ; (II) une PLL de commutation de fréquence délivrant un signal non modulé de fréquence programmable ; et (III) une PLL de synthèse dont l'OCT délivre le signal de sortie du synthétiseur. Ce dernier signal est mélangé au signal de fréquence programmable. Le résultat de ce mélange est soumis à un filtre passe-bande. Un comparateur de phase compare la phase du signal de sortie du filtre passe-bande à celle du signal à fréquence intermédiaire issu de la PLL de modulation. Le filtre passe-bas de la PLL de synthèse filtre le signal de sortie de ce comparateur de phase pour piloter l'OCT. L'intérêt de ce synthétiseur est que le filtre à grande constante de temps de la PLL de modulation, nécessaire à une modulation effective, ne provoque pas un long régime transitoire lors d'une commutation de fréquence. Il est requis que le filtre passe-bande de la PLL de synthèse ait une bande passante étroite autour de la fréquence intermédiaire pour éliminer les produits d'intermodulation indésirables. Il s'agit donc d'un filtre d'ordre élevé, introduisant un déphasage variant sensiblement en fonction de la fréquence. En conséquence, il semble que ce synthétiseur ne puisse fonctionner que si l'OCT de la PLL de synthèse a un domaine de variation de fréquence très étroit, ce qui d'une part nécessite pratiquement une stabilisation de cet OCT par un quartz, et d'autre part pose des difficultés pour rendre le synthétiseur véritablement programmable sur une gamme de fréquences pas trop réduite. Ce document n'aborde aucunement la question d'une possible intégration des composants du synthétiseur avec une architecture permettant de contourner le problème du bruit de phase provoqué par les OCT intégrés.

La présente invention a pour but de permettre d'intégrer dans une large mesure les éléments constituant un dispositif d'émission radio à modulation de fréquence.

L'invention propose ainsi un dispositif d'émission radio à modulation de fréquence, comprenant une source de signal de référence de fréquence fixe, une première boucle à phase asservie comportant un premier oscillateur commandé en tension dont le signal de sortie a une fréquence modulée par un signal d'entrée autour d'un multiple de la fréquence du signal de référence, et une seconde boucle à phase asservie comportant un second oscillateur commandé en tension et des moyens de transposition de fréquence. Les moyens de transposition reçoivent d'une part le signal de sortie du second OCT et d'autre part un signal de transposition de fréquence non modulée. La seconde boucle fournit au second OCT un signal de commande propre à aligner la fréquence du signal de sortie des moyens de transposition sur la fréquence du signal de sortie du premier OCT. Le signal de sortie du second OCT constitue le signal d'émission à modulation de fréquence produit par le dispositif.

Les moyens de transposition comprennent deux mélangeurs et un sommateur agencés pour combiner le signal de sortie du second oscillateur commandé en tension , le signal de transposition et des versions déphasées de $\pi/2$ de ces deux signaux de manière à éliminer du spectre du signal de sortie des moyens de transposition la composante fréquentielle correspondant à la somme de la fréquence du signal de sortie du second oscillateur commandé en tension et de la fréquence du signal de transposition.

La modulation peut alors être effectuée par la première boucle à fréquence relativement basse, de sorte que le premier OCT peut être intégré sans générer un bruit de phase excessif dans la bande passante du signal d'entrée. Le filtre passe-bas de la première boucle peut avoir une fréquence de coupure basse, de l'ordre de 100 Hz par exemple. La transposition à haute fréquence est assurée par la seconde boucle dont le filtre passe-bas peut avoir une fréquence de coupure nettement plus élevée (par exemple quelques dizaines de kHz) pour éliminer le bruit de phase généré par le second OCT fonctionnant à fréquence plus élevée. Les deux boucles peuvent alors être réalisées entièrement sous forme intégrée sur silicium, à l'exception toutefois du filtre de la première boucle dont la fréquence de coupure est basse.

Les moyens de transposition éliminent la principale composante d'intermodulation indésirable (de fréquence $f+f_T$ si f désigne la fréquence de sortie de l'OCT de la seconde boucle et $f_T$ la fréquence du signal de transposition), sans requérir un filtre d'ordre élevé. La seconde boucle peut alors se stabiliser, même si l'excursion en fréquence du signal modulé est relativement importante, sans être perturbée par des fluctuations de la phase.

Le signal de transposition est de préférence produit par un troisième oscillateur commandé en tension inclus dans une troisième boucle à phase asservie, également réalisable sous forme intégrée, la troisième boucle fournissant au troisième OCT un signal de commande réglant la fréquence du signal de transposition sur un multiple de la fréquence du signal de référence. Pour le cas d'un émetteur/récepteur, le troisième OCT peut servir d'oscillateur local pour le premier étage de démodulation en réception.

D'autres particularités et avantages de la présente invention apparaîtront dans la description ci-après d'exemples de réalisation préférés mais non limitatifs, en référence aux dessins annexés, dans lesquels :

la figure 1 est un schéma d'un dispositif d'émission/réception radio à modulation de fréquence selon l'invention ; et
la figure 2 montre une variante de réalisation d'une boucle à phase asservie du dispositif de la figure 1.

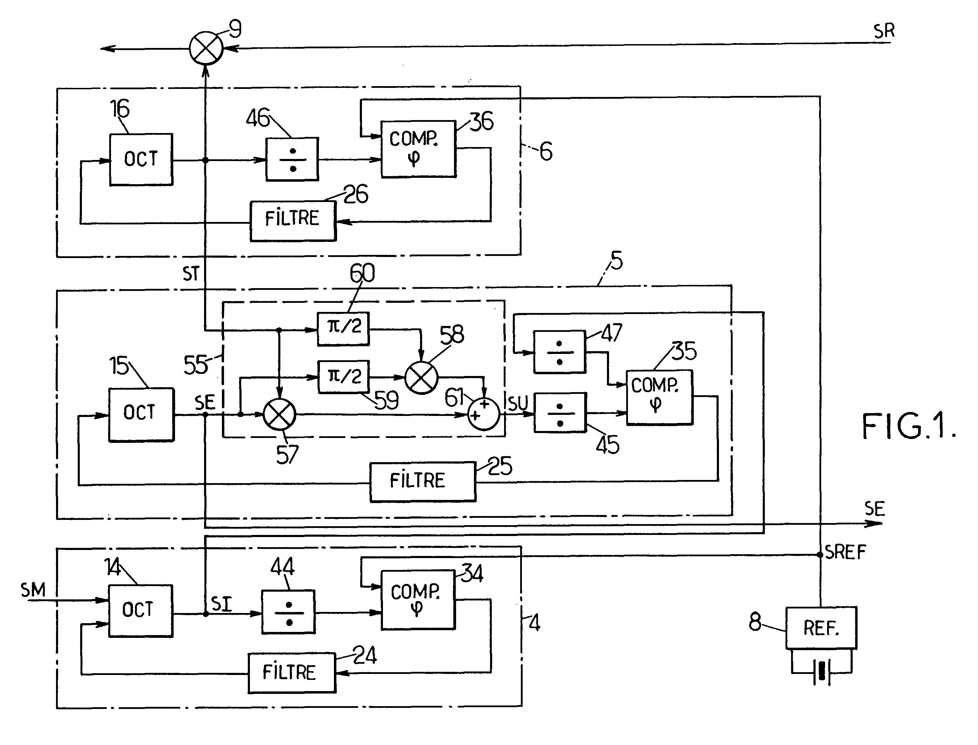

Le dispositif représenté sur la figure 1 comporte trois boucles à phase asservie (PLL) 4, 5, 6. Chaque boucle 4, 5, 6 comporte un oscillateur commandé en tension (OCT) à multivibrateur astable 14, 15, 16, un filtre passe-bas 24, 25, 26 et un comparateur de phase 34, 35, 36. Chaque filtre 24, 25, 26 intègre le signal de comparaison fourni par le comparateur correspondant 34, 35, 36 pour fournir un signal d'asservissement en fréquence à l'oscillateur correspondant 14, 15, 16. Le filtre 24 de la boucle 4 a une fréquence de coupure basse, par exemple de 100 Hz. Les filtres 25, 26 des boucles 5, 6 ont une fréquence de coupure relativement haute, par exemple de 30 kHz.

Le dispositif comprend en outre une source 8 fournissant un signal de référence SREF de fréquence fixe. La source 8 peut être constituée par un oscillateur à cristal associé à un diviseur de fréquence. La fréquence de référence $f_{REF}$ du signal SREF est de valeur relativement élevée, par exemple une fréquence de 557,5 kHz obtenue en divisant par 20 la fréquence fournie par un quartz oscillant à 11,15 MHz. Cette valeur de la fréquence de référence permet d'adopter la fréquence de coupure relativement élevée du filtre passe-bas 26, et donc de réaliser l'OCT 16 sous une forme intégrée.

L'OCT 14 de la première boucle 4 comporte une entrée de modulation recevant le signal d'entrée SM du dispositif, qui est typiquement un signal audio analogique dans la bande passante téléphonique (de 300 à 3400 Hz). Le signal de sortie SI de l'OCT 14 est appliqué à un diviseur de fréquence 44 dont la sortie est reliée à une des entrées du comparateur de phase 34. L'autre entrée du comparateur 34 reçoit le signal de référence SREF. La fréquence du signal SI est ainsi modulée par le signal d'entrée SM autour d'une fréquence $f_I$ qui est un multiple, entier ou fractionnaire, de la fréquence $f_{REF}$ du signal de référence : $f_I = x.f_{REF}$, x désignant le facteur de division de fréquence appliqué par le diviseur 44. Le signal de commande appliqué à l'OCT 14 par le filtre de boucle 24 tend en permanence à ramener sa fréquence d'oscillation vers $f_I$. Du fait de sa fréquence de coupure située en dessous de la bande passante téléphonique, le filtre 24 ne supprime pas la modulation de fréquence par le signal d'entrée SM. La fréquence $f_I$ est choisie suffisamment basse (par exemple 4,3 MHz), pour que l'oscillateur intégré 14 à multivibrateur astable ne génère pas un bruit de phase excessif dans la bande passante téléphonique.

Le signal de référence SREF est également appliqué à une entrée du comparateur de phase 36 de la troisième boucle 6. L'autre entrée de ce comparateur 36 est reliée à un diviseur de fréquence 46 recevant le signal de sortie ST de l'OCT 16. L'oscillateur 16 délivre un signal de transposition ST de fréquence $f_T$ proportionnelle à la fréquence de référence : $f_T=y.f_{REF}$, y désignant le facteur de division de fréquence appliqué par le diviseur 46. L'oscillateur 16 sert d'oscillateur local pour le premier étage de démodulation du signal radio SR reçu par le dispositif. Le signal de transposition ST est ainsi appliqué au mélangeur 9 du premier étage de démodulation qui assure une transposition de fréquence vers une première fréquence intermédiaire $f'_I$. Si le signal reçu SR est modulé autour d'une fréquence $f_R$, la fréquence $f_T$ du signal de transposition est par exemple égale à la somme de la fréquence intermédiaire $f'_I$ et de la fréquence $f_R$. Des valeurs numériques typiques sont $f_R=26,4$ MHz, $f'_I=10,7$ MHz (norme française CT0 pour les liaisons de la base vers le combiné), et donc $f_T=37,1$ MHz.

La seconde boucle à phase asservie 5 comporte des moyens de transposition de fréquence 55 recevant d'une part le signal de sortie SE de l'oscillateur 15, et d'autre part le signal de transposition ST fourni par l'oscillateur 16. Ces moyens de transposition 55 comprennent deux mélangeurs 57, 58, deux déphaseurs de $\pi/2$ 59, 60, et un additionneur 61. Le mélangeur 57 a deux entrées recevant respectivement les signaux SE et ST, et une sortie reliée à une entrée de l'additionneur 61. Le mélangeur 58 a deux entrées recevant respectivement les signaux SE et ST déphasés de $\pi/2$ par les déphaseurs 59, 60, et une sortie reliée à l'autre entrée de l'additionneur 61. L'additionneur 61 fournit le signal de sortie SU des moyens de transposition 55. La combinaison appliquée par les moyens 55 élimine du spectre du signal SU les composantes fréquentielles correspondant aux sommes des fréquences contenues dans les signaux SE et ST.

La boucle 5 asservit la fréquence d'oscillation de l'OCT 15 de manière à faire coïncider la fréquence du signal de sortie SU des moyens de transposition 55 avec la fréquence du signal de sortie SI de l'OCT 14 de la première boucle 4. Selon les caractéristiques du comparateur de phase 35, il peut être utile de diviser les fréquences des signaux SU et SI avant de les lui appliquer. On peut ainsi prévoir que la seconde boucle 5 comporte deux diviseurs de fréquence de même rapport, l'un 45 recevant le signal SU et relié à une entrée du comparateur 35, et l'autre 47 recevant le signal SI et relié à l'autre entrée du comparateur 35. Le facteur de division de fréquence appliqué par les diviseurs 45, 47 est par exemple de 4 pour que le comparateur de phase 35 fonctionne à une fréquence de l'ordre de 1 MHz.

Le signal de sortie SE de l'OCT 15 constitue le signal d'émission à modulation de fréquence produit par le dispositif. La fréquence f de ce signal SE est modulée conformément au signal d'entrée SM autour de la fréquence $f_E = f_T + f_I$. Les moyens de transposition 55, tels qu'ils sont agencés dans la boucle 5, permettent d'éliminer du spectre de l'oscillateur 15 les composantes de fréquence voisine de $f_T - f_I$. Le bruit de phase que peut introduire l'oscillateur 15 à multivibrateur astable est compensé par le filtre 25 dont la fréquence de coupure est relativement haute, sans affecter la modulation incluse dans la référence SI appliquée au comparateur de phase 35. Dans le cas particulier des liaisons combiné vers base de la norme française CT0, où le signal d'émission SE doit être modulé autour d'une fréquence $f_E = 41,4$ MHz, on est donc amené à choisir une fréquence intermédiaire $f_I = f_E - f_T = f_E - f_R - f_I' = 4,3$ MHz.

Le dispositif représenté sur la figure 1 peut également convenir pour supporter plusieurs canaux d'émission et de réception, notamment lorsque l'écart duplex (écart entre les fréquences d'émission et de réception) est constant. Dans ce cas, un changement de canal en émission et en réception est simplement effectué en modifiant le facteur de division appliqué par le diviseur 46 de la troisième boucle 6. Ce diviseur 46 est donc de préférence réglable et à rapport fractionnaire. On observe que la première boucle 4 assurant la modulation par le signal d'entrée SM n'apporte pas de retard sur l'établissement des fréquences lors d'un changement de canal.

Grâce aux fréquences de coupure élevées des filtres 25 et 26, il est également possible de les réaliser sous forme intégrée. Ainsi, dans une application pratique de l'invention, les trois boucles 4, 5, 6 peuvent être intégrées sur la même puce de silicium, à l'exception du filtre 24 de la première boucle dont la fréquence de coupure est relativement basse.

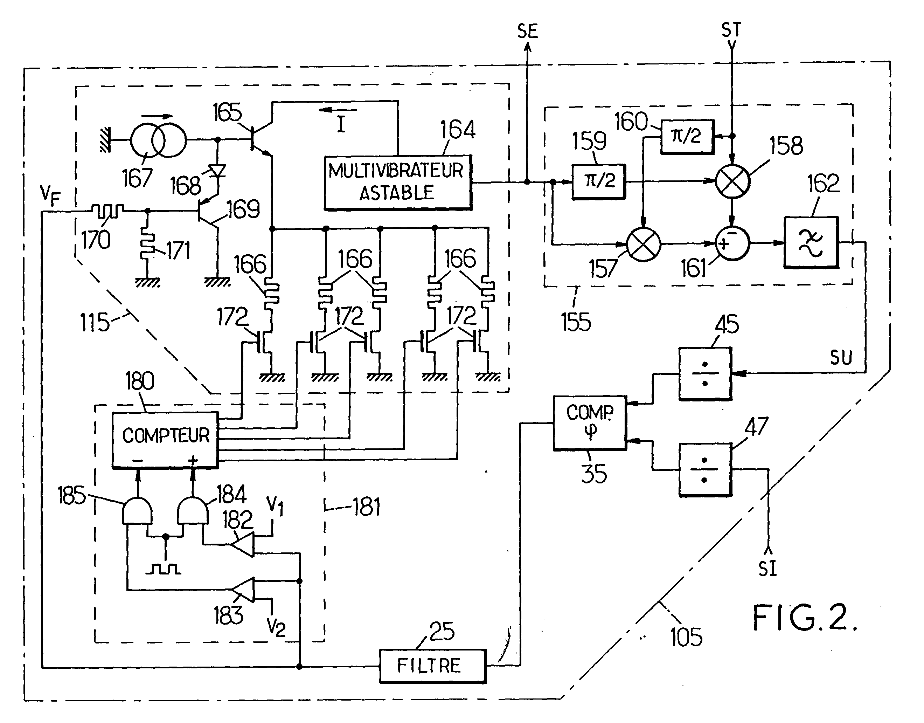

On note que la combinaison appliquée par les mélangeurs et le sommateur des moyens de transposition de fréquence pour éliminer du signal SU les composantes de fréquence $f + f_T$ peut être différente de celle illustrée sur la figure 1. Ainsi, dans l'exemple des moyens de transposition 155 représentés sur la figure 2, le sommateur (qui s'entend généralement comme réalisant une somme algébrique) est un soustracteur 161 dont les entrées sont reliées aux sorties respectives des deux mélangeurs 157, 158. Le mélangeur 157 reçoit le signal SE et le signal de transposition ST déphasé de $\pi/2$ par le déphaseur 160, tandis que le mélangeur 158 reçoit le signal ST et le signal SE déphasé de $\pi/2$ par le déphaseur 159. La combinaison ainsi produite en sortie du soustracteur 161 diffère seulement par un déphasage constant de $\pi/2$ par rapport à celle produite en sortie de l'additionneur 61 de la figure 1.

Comme le montre la figure 2, le sommateur 161 des moyens de transposition de fréquence 155 peut être suivi par un filtre passe-bas 162 dont le but est d'atténuer dans le signal SU les composantes d'intermodulation d'ordre 2, de fréquences $2f_T - f_E$, $2f_E - f_T$, $3f_T - f_E$ etc... Ce filtre doit être de petit ordre et de pente relativement faible pour ne pas induire de dépendance phase/fréquence autour de la fréquence $f_I$. Dans le cas des valeurs numériques précédemment mentionnées, la fréquence de coupure du filtre 162 est par exemple de l'ordre de 12 MHz.

La figure 2 montre une boucle 105 utilisable à la place de la seconde boucle 5 dans un dispositif tel que celui de la figure 1. Les diviseurs de fréquence 45, 47, le comparateur de phase 35 et le filtre de boucle 25 sont agencés de la même manière que dans le mode de réalisation de la figure 1.

La figure 2 montre le multivibrateur astable 164 de l'OCT 115 de la seconde boucle 105. La fréquence f du signal de sortie SE du multivibrateur 164 est proportionnelle à un courant de commande I fourni par le collecteur d'un transistor npn 165. L'émetteur de ce transistor 165 est relié à la masse par l'intermédiaire d'un réseau programmable de résistances en parallèle 166, dont on note $R_{DA}$ la valeur ohmique globale. Un générateur de courant 167 a sa sortie reliée d'une part à la base du transistor npn 165, et d'autre part, par l'intermédiaire d'une diode 168, à l'émetteur d'un transistor pnp 169 dont le collecteur est à la masse. La base du transistor 169 est reliée à deux résistances, l'une 170 de valeur ohmique $R_1$ recevant la tension de sortie $V_F$ du filtre de boucle 25, et l'autre 171 de valeur ohmique $R_2$ reliée à la masse. Avec cet agencement de l'OCT 115, la fréquence f du signal SE est proportionnelle au courant I donné par

$$I = \frac{1}{R_{DA}} \left( V_{BE} + \frac{R_1}{R_1 + R_2} V_F \right)$$

où $V_{BE}$ est la tension base-émetteur du transistor 165. Cette relation met en évidence la relation linéaire entre la tension de commande $V_F$ de l'OCT et la fréquence de sortie. Elle fait également apparaître un facteur d'échelle programmable $1/R_{DA}$.

Par la programmation de ce facteur $1/R_{DA}$, chaque résistance 166 du réseau est reliée à la masse par l'intermédiaire d'un commutateur MOS 172 commandé par un bit respectif de sortie d'un compteur numérique 180. Les résistances 166 ont des valeurs ohmiques individuelles échelonnées par puissances de 2, de telle sorte que le facteur $1/R_{DA}$ soit proportionnel à la valeur du compteur 180.

Le compteur 180 fait partie d'un circuit logique 181 dont le rôle est d'activer périodiquement une variation pas à pas de la fréquence de sortie de l'OCT 115 lorsque la sortie du comparateur de phase 35 sort du domaine linéaire. A cette fin, le circuit logique 181 comporte, dans l'exemple représenté, deux comparateurs de tension 182, 183 et deux portes ET 184, 185. Ces deux portes reçoivent un signal d'horloge, de fréquence 1 kHz par exemple, fixant la période de la variation pas à pas. La porte 184 est reliée à la sortie du comparateur 182 pour commander l'incrémentation du compteur 180 lorsque la tension de sortie $V_F$ du filtre de boucle 25 est inférieure à un seuil $V_1$. La porte 185 est reliée à la sortie du comparateur 183 pour commander la décrémentation du compteur 180 lorsque la tension $V_F$ dépasse un seuil $V_2$. Ces seuils $V_1$ et $V_2$ sont choisis pour encadrer le domaine linéaire du comparateur de phase 35 (par exemple $V_1$=0,5 V, $V_2$=$V_{DD}$-$V_1$ où $V_{DD}$ désigne la tension de référence positive du circuit intégré).

Cette variation pas à pas du facteur d'échelle $1/R_{DA}$ garantit l'indépendance du fonctionnement du dispositif vis-à-vis des variations dues aux procédés de fabrication de semi-conducteurs. Elle assure en outre l'accrochage de la boucle dans de larges domaines de valeurs pour les fréquences $f_E$ et $f_T$.

Lorsqu'un filtre passe-bas 162 est utilisé dans les moyens de transposition de fréquence 155, il est possible de détecter les transitions en sortie de ce filtre et de modifier la valeur de compteur 180, pour recycler la variation pas à pas de la fréquence de l'OCT, lorsqu'aucune transition n'est détectée. Ceci évite qu'à l'initialisation un écart important (supérieur à la bande passante du filtre 162) entre les fréquences $f_T$ et $f_E$ empêche une stabilisation correcte de la boucle.

## Revendications

1. Dispositif d'émission radio à modulation de fréquence, comprenant une source (8) de signal de référence de fréquence fixe, une première boucle à phase asservie (4) comportant un premier oscillateur commandé en tension (14) dont le signal de sortie (SI) a une fréquence modulée par un signal d'entrée (SM) du dispositif autour d'un multiple ($f_I$) de la fréquence du signal de référence (SREF), et une seconde boucle à phase asservie (5 ; 105) comportant un second oscillateur commandé en tension (15 ; 115) et des moyens de transposition de fréquence (55 ; 155), les moyens de transposition recevant d'une part le signal de sortie (SE) du second oscillateur commandé en tension et d'autre part un signal de transposition (ST) de fréquence non modulée ($f_T$), la seconde boucle à phase asservie fournissant au second oscillateur commandé en tension un signal de commande propre à aligner la fréquence du signal de sortie (SU) des moyens de transposition sur la fréquence du signal de sortie (SI) du premier oscillateur commandé en tension (4), le signal de sortie (SE) du second oscillateur commandé en tension constituant le signal d'émission à modulation de fréquence produit par le dispositif, caractérisé en ce que les moyens de transposition (55 ; 155) comprennent deux mélangeurs (57,58 ; 157,158) et un sommateur (61 ; 161) agencés pour combiner le signal de sortie (SE) du second oscillateur commandé en tension (15 ; 115), le signal de transposition (ST) et des versions déphasées de $\pi/2$ de ces deux signaux de manière à éliminer du spectre du signal de sortie (SU) des moyens de transposition la composante fréquentielle correspondant à la somme de la fréquence du signal de sortie (SE) du second oscillateur commandé en tension et de la fréquence ($f_T$) du signal de transposition (ST).

2. Dispositif selon la revendication 1, caractérisé en ce que le signal de transposition (ST) est produit par un troisième oscillateur commandé en tension (16) inclus dans une troisième boucle à phase asservie (6), la troisième boucle à phase asservie fournissant au troisième oscillateur commandé en tension un signal de commande réglant la fréquence ($f_T$) du signal de transposition sur un multiple de la fréquence ($f_{REF}$) du signal de référence.

3. Dispositif selon la revendication 2, convenant en outre pour la réception d'un signal radio à modulation de fréquence (SR), caractérisé en ce que le signal de transposition (ST) est en outre appliqué à un mélangeur (9) d'un premier étage de démodulation radio, assurant une transposition du signal radio reçu vers une fréquence intermédiaire ($f_I'$).

4. Dispositif selon la revendication 3, caractérisé en ce que la fréquence ($f_T$) du signal de transposition (ST) est égale à la somme de ladite fréquence intermédiaire ($f_I'$) et de la fréquence ($f_R$) autour de laquelle est modulé le signal radio reçu, et en ce que la fréquence ($f_I$) autour de laquelle est modulé le signal de sortie du premier oscillateur commandé en tension (14) est égale à la différence entre la fréquence ($f_E$) autour de laquelle le signal d'émission (SE) est à moduler et la fréquence de transposition ($f_T$).

5. Dispositif selon l'une quelconque des revendications 1 à 4, caractérisé en ce que les moyens de transposition (55) comprennent un premier mélangeur (57) recevant le signal de sortie (SE) du second oscillateur commandé en tension (15) et le signal de transposition (ST), deux déphaseurs de $\pi/2$ (59,60) recevant l'un le signal de sortie du second oscillateur commandé en tension et l'autre le signal de transposition, un second mélangeur (58) recevant les signaux de sortie respectifs des deux déphaseurs, et un additionneur (61) recevant les signaux de sortie respectifs des premier et second mélangeurs et délivrant le signal de sortie (SU) des moyens de transposition.

6. Dispositif selon l'une quelconque des revendications 1 à 5, caractérisé en ce que chacun des oscillateurs commandés en tension (14, 15, 16 ; 115) comprend un multivibrateur astable intégré.

7. Dispositif selon la revendication 6, caractérisé en ce que les boucles à phase asservie (4, 5, 6) sont entièrement intégrées dans une seule puce à l'exception d'un filtre passe-bas (24) appartenant à la première boucle à phase asservie.

8. Dispositif selon l'une quelconque des revendications 1 à 7, caractérisé en ce que la seconde boucle à phase asservie (105) comporte un circuit logique (181) pour provoquer une variation pas à pas de la fréquence de sortie du second oscillateur commandé en tension (115) lorsqu'une tension de commande de ($V_F$) adressée au second oscillateur commandé en tension sort d'un intervalle prédéterminé ([$V_1$, $V_2$]).

**Patentansprüche**

1. Frequenzmodulierter Funksender, welcher eine Bezugssignalquelle (8) für ein Bezugssignal mit unveränderlicher Frequenz, eine erste phasengeregelte Schleife (4) mit einem ersten spannungsgesteuerten Oszillator (14), dessen Ausgangssignal (SI) eine mit einem Eingangssignal (SM) der Vorrichtung modulierten Frequenz um ein Mehrfaches ($f_I$) der Bezugssignalfrequenz (SREF) besitzt, und eine zweite phasengeregelte Schleife (5; 105) mit einem zweiten spannungsgesteuerten Oszillator (15; 115) und mit einer Frequenzumsetzeinrichtung (55; 155) aufweist, wobei die Umsetzeinrichtung zum einen das Ausgangssignal (SE) des zweiten spannungsgesteuerten Oszillators und zum anderen ein unmoduliertes ($f_T$) Frequenzumsetzsignal (ST) übernimmt, wobei die zweite phasengeregelte Schleife an den zweiten spannungsgesteuerten Oszillator ein Steuersignal abgibt, welches zum Abgleichen der Frequenz des Ausgangssignals (SU) der Umsetzeinrichtung mit der Frequenz des Ausgangssignals (SI) des ersten spannungsgesteuerten Oszillators (4) geeignet ist, wobei das Ausgangssignal (SE) des zweiten spannungsgesteuerten Oszillators das frequenzmodulierte Sendesignal darstellt, welches von der Sendervorrichtung erzeugt wird, dadurch gekennzeichnet, dass die Umsetzeinrichtung (55; 155) zwei Mischstufen (57, 58; 157, 158) und ein Summierungsglied (61; 161) aufweist, welche zum Verknüpfen de Ausgangssignals (SE) des zweiten spannungsgeregelten Oszillators (15; 115), des Umsetzsignals (ST) und der phasenverschobenen Versionen von $\pi/2$ dieser beiden Signale in der Weise vorgesehen sind, dass aus dem Spektrum des Ausgangssignals (SU) der Umsetzeinrichtung die Frequenzkomponente entfernt wird, welche der Summe aus der Frequenz des Ausgangssignals (SE) des zweiten spannungsgesteuerten Oszillators und der Frequenz ($f_T$) des Umsetzsignals (ST) entspricht.

2. Funksender nach Anspruch 1, dadurch gekennzeichnet, dass das Umsetzsignal (ST) von einem dritten spannungsgesteuerten Oszillator (16) erzeugt wird, welcher in einer dritten phasengeregelten Schleife (6) einbezogen ist, wobei die dritte phasengeregelte Schleife an den dritten spannungsgeregelten Oszillator ein Steuersignal abgibt, welches die Frequenz ($f_T$) des Umsetzsignals auf ein Mehrfaches der Frequenz ($f_{REF}$) des Bezugssignals regelt.

3. Funksender nach Anspruch 2, welcher sich außerdem zum Empfang eines frequenzmodulierten Funksignals (SR) eignet, dadurch gekennzeichnet, dass das Umsetzsignal (ST) außerdem an eine Mischstufe (9) einer ersten Funkdemodulationsstufe angelegt ist, wodurch eine Umsetzung des empfangenen Funksignals auf eine Zwischenfrequenz ($f_I'$) gewährleistet ist.

4. Funksender nach Anspruch 3, dadurch gekennzeichnet, dass die Frequenz (fT) des Umsetzsignals (ST) gleich der Summe aus der Zwischenfrequenz ($f_I'$) und der Frequenz ($f_R$) ist, um welche das empfangene Funksignal moduliert wird, und dass die Frequenz ($f_I$), um welche das Ausgangssignal des ersten spannungsgesteuerten Oszillators (14) moduliert wird, gleich der Differenz zwischen der Frequenz ($f_E$), um welche das Sendesignal (SE) zu modulieren ist, und der Umsetzfrequenz ($f_T$) ist.

5. Funksender nach einem der vorhergehenden Ansprüche, dadurch gekennzeichnet, dass die Umsetzeinrichtung (55) eine erste Mischstufe (57) aufweist, welche das Ausgangssignal (SE) des zweiten spannungsgesteuerten Oszillators (15) und das Umsetzsignal (ST) empfängt, sowie zwei Phasenschieber (59, 60) zur Phasenverschiebung um $\pi/2$,

von denen der eine das Ausgangssignal des zweiten spannungsgesteuerten Oszillators und der andere das Umsetzsignal empfängt, wobei eine zweite Mischstufe (58) die jeweiligen Ausgangssignale der beiden Phasenschieber empfängt und ein Addierglied (61) die jeweiligen Ausgangssignale aus der ersten und zweiten Mischstufe übernimmt und das Ausgangssignal (SU) der Umsetzeinrichtung abgibt.

6. Funksender nach einem der Ansprüche 1 bis 5, dadurch gekennzeichnet, dass jeder der spannungsgesteuerten Oszillatoren (14, 15, 16; 115) eine integrierte astabile Kippschaltung umfasst.

7. Funksender nach Anspruch 6, dadurch gekennzeichnet, dass die phasengeregelten Schleifen (4, 5, 6) - mit Ausnahme eines zur ersten phasengeregelten Schleife gehörigen Tiefpassfilters (24) - vollständig in einen einzigen Chip integriert sind.

8. Funksender nach einem der Ansprüche 1 bis 7, dadurch gekennzeichnet, dass die zweite phasengeregelte Schleife (105) einen Logikkreis (181) aufweist, um eine schrittweise Veränderung der Ausgangsfrequenz des spannungsgesteuerten zweiten Oszillators (115) hervorzurufen, wenn eine an den zweiten spannungsgesteuerten Oszillator adressierte Steuerspannung ($V_F$) aus einem vorgegebenen Intervall ([V1, V2]) kommt.

## Claims

1. A frequency modulation radio transmission device, comprising a fixed frequency reference signal source (8), a first phase-locked loop (4) including a first voltage-controlled oscillator (14) whose output signal (SI) has a frequency modulated by an input signal (SM) of the device about a multiple ($f_I$) of the frequency of the reference signal (SREF), and a second phase-locked loop (5 ; 105) including a second voltage-controlled oscillator (15 ; 115) and frequency transposition means (55 ; 155), the transposition means receiving on the one hand the output signal (SE) of the second voltage-controlled oscillator and on the other hand a transposition signal (ST) having a non-modulated frequency ($f_T$), the second phase-locked loop addressing to the second voltage-controlled oscillator a control signal capable of aligning the frequency of the output signal (SU) of the transposition means with the frequency of the output signal (SI) of the first voltage-controlled oscillator (4), wherein the output signal (SE) of the second voltage-controlled oscillator forms the frequency modulation transmission signal produced by the device, characterized in that the transposition means (55 ; 155) include two mixers (57, 58 ; 157, 158) and a summer (61 ; 161) arranged to combine the output signal (SE) of the second voltage-controlled oscillator (15 ; 115), the transposition signal (ST) and π/2-phase shifted versions of those two signals so as to eliminate from the spectrum of the output signal (SU) of the transposition means the frequency component corresponding to the sum of the frequency of the output signal (SE) of the second voltage-controlled oscillator and of the frequency ($f_T$) of the transposition signal (ST).

2. A device according to claim 1, characterized in that the transposition signal (ST) is produced by a third voltage-controlled oscillator (16) included in a third phase-locked loop (6), the third phase-locked loop addressing to the third voltage-controlled oscillator a control signal which adjusts the frequency ($f_T$) of the transposition signal as a multiple of the frequency ($f_{REF}$) of the reference signal.

3. A device according to claim 2, which is further suitable for receiving a frequency modulation radio signal (SR), characterized in that the transposition signal (ST) is further applied to a mixer (9) of a first radio demodulation stage which ensures a transposition of the received radio signal toward an intermediate frequency ($f_I'$).

4. A device according to claim 3, characterized in that the frequency ($f_T$) of the transposition signal (ST) is equal to the sum of said intermediate frequency ($f_I'$) and of the frequency ($f_R$) about which the received radio signal is modulated, and in that the frequency ($f_I$) about which the output signal of the first voltage-controlled oscillator (14) is modulated is equal to the difference between the frequency ($f_E$) about which the transmission signal (SE) is to be modulated and the transposition frequency ($f_T$).

5. A device according to any one of claims 1 to 4, characterized in that the transposition means (55) include a first mixer (57) receiving the output signal (SE) of the second voltage-controlled oscillator (15) and the transposition signal (ST), two π/2-phase shifters (59, 60), one receiving the output signal of the second voltage-controlled oscillator, and the other one receiving the transposition signal, a second mixer (58) receiving the respective output signals of the two phase shifters, and an adder (61) receiving the respective output signals of the first and second mixers and delivering the output signal (SU) of the transposition means.

6. A device according to any one of claims 1 to 5, characterized in that each of said voltage-controlled oscillators (14, 15, 16 ; 115) comprises an integrated astable multivibrator.

**7.** A device according to claim 6, characterized in that said phase-locked loops (4, 5, 6) are entirely integrated in a single chip, except a low-pass filter (24) forming part of the first phase-locked loop.

**8.** A device according to any one of claims 1 to 7, characterized in that the second phase-locked loop (105) includes a logic circuit (181) to cause a stepping variation of the output frequency of the second voltage-controlled oscillator (115) when a control voltage ($V_F$) addressed to the second voltage-controlled oscillator is out of a predetermined interval ($[V_1, V_2]$).

FIG.1.

FIG.2.